# EUROPEAN PATENT APPLICATION

(11) **EP 4 746 626 A1**
(43) Date of publication of application: **20.05.2026**
(21) Application number: 25210335.3
(22) Date of filing: 22.10.2025
(51) Int. Cl.: H10D 30/01, H10D 30/47, H10D 62/80, H10D 64/01, H10D 64/27

(54) **SEMICONDUCTOR DEVICE AND SEMICONDUCTOR DEVICE MANUFACTURING METHOD**

(30) Priority: 15.11.2024 KR 20240163347
(71) Applicant: Samsung Electronics Co., Ltd., Suwon-si, Gyeonggi-do 16677 (KR)
(72) Inventor: Yang, Eunji, 16678 Suwon-si, Gyeonggi-do (KR); Park, Baekwon, 16678 Suwon-si, Gyeonggi-do (KR); Kim, Changhyun, 16678 Suwon-si, Gyeonggi-do (KR)
(74) Representative: Grünecker Patent- und Rechtsanwälte PartG mbB

(57) **Abstract**

A semiconductor device includes a substrate, a source electrode on the substrate, a drain electrode being apart from the source electrode, a channel connecting the source electrode to the drain electrode and including a two-dimensional material, a gate insulating layer on the channel, and a gate electrode on the gate insulating layer, wherein the gate electrode includes an overlap area facing the source electrode in a vertical direction.

## Description

### BACKGROUND

### 1. Field

The disclosure relates to semiconductor devices and semiconductor device manufacturing methods.

### 2. Description of the Related Art

As semiconductor devices performing an electrical switching function, transistors have been used in various integrated circuit (IC) devices including memories, driving ICs, logic devices, and the like. In order to increase the integration degree of IC devices, the space occupied by transistors arranged therein has rapidly decreased, and thus, research has been conducted to reduce the size of transistors while maintaining the performance thereof.

One of the important components of a transistor is a gate electrode. When a voltage is applied to the gate electrode, a channel adjacent to a gate opens a path for a current, and in the opposite case, the channel blocks a current. The performance of the semiconductor depends on how much to reduce a contact resistance and how much to reduce and how efficiently to manage a leakage current at the gate electrode and the channel. As the area in which the channel and the gate electrode controlling a current in the transistor contact each other increases, power efficiency increases.

As a semiconductor process becomes more refined, a transistor size decreases and the area in which a gate electrode and a channel contact each other decreases, thus causing problems due to a short channel effect. For example, there are phenomena such as threshold voltage variation, carrier velocity saturation, and deterioration of subthreshold characteristics. Accordingly, methods of overcoming the short channel effect and/or effectively reducing the channel length have been sought.

### SUMMARY

Some example embodiments of the disclosure provide a semiconductor devices capable of reducing contact resistance.

Some example embodiments of the disclosure provide a semiconductor device manufacturing methods capable of reducing contact resistance.

Additional aspects will be set forth in part in the description which follows and, in part, will be apparent from the description, or may be learned by practice of the presented example embodiments of the disclosure.

According to an example embodiment of the disclosure, a semiconductor device includes a substrate, a source electrode on the substrate, a drain electrode on the substrate, the drain electrode being apart from the source electrode, a channel being between the source electrode and the drain electrode, the channel connecting the source electrode to the drain electrode, the channel including a two-dimensional material, a gate insulating layer on the channel, and a gate electrode on the gate insulating layer, wherein the gate electrode has an asymmetrical structure in terms of an overlap area facing a corresponding one of the source electrode and the drain electrode in a vertical direction and the gate electrode comprises the overlap area facing the source electrode in the vertical direction.

The gate insulating layer may have an asymmetrical structure in terms of an upper surface portion thereof facing a corresponding one of the source electrode and the drain electrode in the vertical direction, and the gate insulating layer may include the upper surface portion facing the source electrode in the vertical direction.

The gate electrode may have no area facing the drain electrode in the vertical direction.

The channel may include at least one of a transition metal dichalcogenide (TMD) material, graphene, black phosphorus, amorphous boron nitride, or phosphorene.

The TMD material may include a metal element selected from Mo, W, Nb, V, Ta, Ti, Zr, Hf, Tc, Re, Cu, Ga, In, Sn, Ge, and Pb and a chalcogen element selected from S, Se, and Te.

The gate insulating layer may include at least one of a high-k material or a ferroelectric material.

The channel may include a plurality of channel layers, the plurality of channel layers being apart from each other in a direction away from the substrate.

The plurality of channel layers may have a structure in which both end portions thereof are buried in the source electrode and the drain electrode.

The semiconductor device may further include a spacer between a corresponding pair of the plurality of channel layers, the spacer supporting the corresponding pair of the plurality of channel layers.

The spacer may include at least one of SiO₂, SiN, or a-BN.

The spacer may include a first spacer adjacent to the source electrode and a second spacer adjacent to the drain electrode.

The first spacer may have a smaller thickness than the second spacer.

According to an example embodiment of the disclosure, a semiconductor device includes a substrate, a source electrode on the substrate, a drain electrode on the substrate, the drain electrode being apart from the source electrode, a channel being between the source electrode and the drain electrode, the channel connecting the source electrode to the drain electrode, the channel including a two-dimensional material, the channel including a plurality of channel layers , the plurality of channel layers being apart from each other in a direction away from the substrate, a spacer between a corresponding pair of the plurality of channel layers, the spacer supporting the corresponding pair of the plurality of channel layers, a gate insulating layer on the plurality of channel layers, and a gate electrode on the gate insulating layer, wherein the spacer includes a first spacer adjacent to the source electrode and a second spacer adjacent to the drain electrode, and the first spacer has a smaller thickness than the second spacer.

According to an example embodiment of the disclosure, a semiconductor device manufacturing method includes alternately stacking a sacrificial layer and a channel on a substrate, the channel including a two-dimensional material, patterning a stack structure of the sacrificial layer and the channel by using a mask, forming a source electrode and a drain electrode on both sides of the patterned stack structure, respectively, removing the sacrificial layer such that the channel is suspended between the source electrode and the drain electrode, the channel including a plurality of channel layers, the plurality of channel layers being formed apart from each other in a direction perpendicular to the substrate, forming a first spacer adjacent to the source electrode and a second spacer adjacent to the drain electrode, between an adjacent pair of the plurality of channel layers, depositing a gate insulating layer on the channel, and depositing a gate electrode on the gate insulating layer, wherein the first spacer has a smaller thickness than the second spacer.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a perspective view of a semiconductor device according to an example embodiment;
FIG. 2 is a cross-sectional view taken along line A-A of FIG. 1;
FIG. 3 is a cross-sectional view taken along line B-B of FIG. 1;
FIG. 4 illustrates a transmission electron microscope (TEM) image of a semiconductor device according to an example embodiment;
FIG. 5 illustrates a schematic cross-sectional view of a semiconductor device according to an example embodiment;
FIG. 6 illustrates a cross-sectional view of a semiconductor device according to a comparative example;
FIG. 7 illustrates a V_{g}-I_{d} graph of a semiconductor device according to an example embodiment and a semiconductor device according to a comparative example;
FIG. 8 illustrates a semiconductor device according to a comparative example and an energy band diagram thereof;
FIG. 9 illustrates an energy band diagram according to source/drain electrical doping;
FIG. 10 illustrates an energy band diagram according to drain voltage application;
FIG. 11 illustrates an energy band diagram according to source area asymmetric electrical doping;
FIG. 12 illustrates an energy band diagram according to source area asymmetric electrical doping and drain voltage application;
FIG. 13 illustrates a cross-sectional view of a semiconductor device according to another example embodiment;
FIG. 14 illustrates an example of modifying a spacer structure in FIG. 13;
FIG. 15 illustrates an example of further including a spacer in FIG. 1;
FIG. 16 illustrates an example of modifying a channel structure in FIG. 15;
FIGS. 17 to 25B illustrate a semiconductor device manufacturing method according to an example embodiment;
FIGS. 26A to 28B illustrate a semiconductor device manufacturing method according to another example embodiment;
FIG. 29 is a schematic block diagram of a display driver IC (DDI) including a semiconductor device and a display apparatus including the DDI according to an example embodiment;
FIG. 30 is a circuit diagram of an inverter including a semiconductor device according to an example embodiment;
FIG. 31 is a circuit diagram of an SRAM device including a semiconductor device according to an example embodiment;
FIG. 32 is a circuit diagram of a NAND circuit including a semiconductor device according to an example embodiment;
FIG. 33 is a block diagram of an electronic system including a semiconductor device according to an example embodiment; and
FIG. 34 is a block diagram of an electronic system including a semiconductor device according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Hereinafter, semiconductor devices and semiconductor device manufacturing methods according to various example embodiments will be described in detail with reference to the accompanying drawings. Like reference numerals in the drawings will denote like elements, and sizes of elements in the drawings may be exaggerated for clarity and convenience of description. Although terms such as "first" and "second" may be used herein to describe various elements or components, these elements or components should not be limited by these terms. These terms are only used to distinguish one element or component from another element or component.

**As** used herein, the singular forms "a", "an", and "the" are intended to include the plural forms as well, unless the context clearly indicates otherwise. Also, when something is referred to as "including" a component, another component may be further included unless specified otherwise. Also, in the drawings, the size or thickness of each element may be exaggerated for clarity of description. Also, when a material layer is referred to as being "on" a substrate or another layer, it may be directly on the substrate or the other layer or one or more intervening layers may be present therebetween. Also, in the following example embodiments, because materials forming each layer are just examples, other materials may also be used.

Also, as used herein, the terms "units" and "modules" may refer to units that perform at least one function or operation, and the units may be implemented as hardware or software or a combination of hardware and software.

Particular implementations described in the present example embodiments are just examples, and do not limit the scope of the disclosure in any way. For the sake of conciseness, descriptions of related art electronic configurations, control systems, software, and other functional aspects of the systems may be omitted. Also, connections or connection members of lines between the elements illustrated in the drawings may illustratively represent functional connections and/or physical or logical connections and may be represented as various replaceable or additional functional connections, physical connections, or logical connections in an actual apparatus.

The use of the terms "a", "an", and "the" and other similar indicative terms may be construed to cover both the singular and the plural.

Operations of a method described herein may be performed in any suitable order unless otherwise specified. Also, example terms (e.g., "such as" and "and/or the like") used herein are merely intended to describe the technical concepts of the disclosure in detail, and the scope of the disclosure is not limited by the example terms unless otherwise defined in the appended claims.

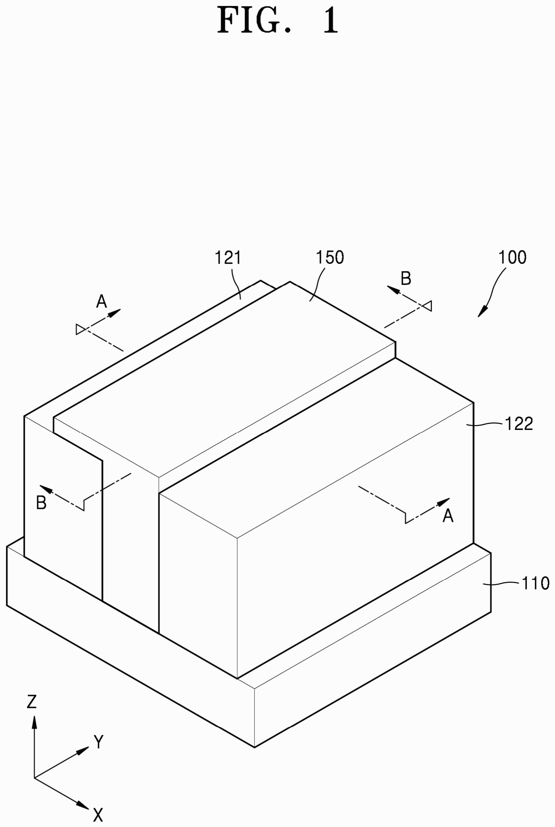

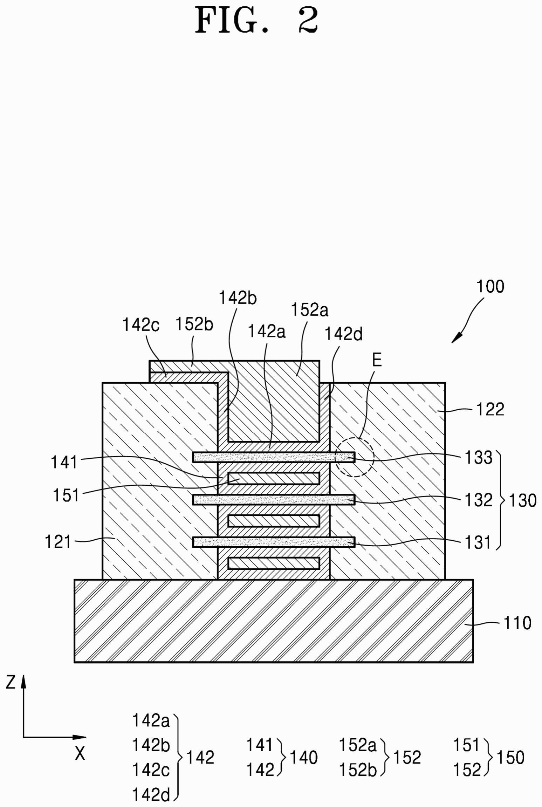

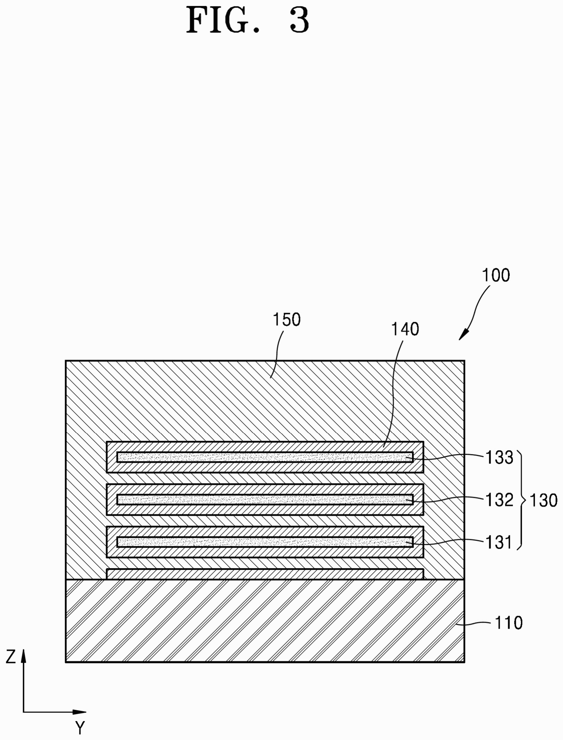

FIG. 1 is a perspective view of a semiconductor device according to an example embodiment, FIG. 2 is a cross-sectional view taken along line A-A of FIG. 1, and FIG. 3 is a cross-sectional view taken along line B-B of FIG. 1.

Referring to FIGS. 1, 2, and 3, a semiconductor device 100 may include a substrate 110, a source electrode 121 arranged on the substrate 110, a drain electrode 122 arranged apart from the source electrode 121 on the substrate 110, a channel 130 connected between the source electrode 121 and the drain electrode 122, and a gate electrode 150 arranged to be insulated from the source electrode 121 and the drain electrode 122. A gate insulating layer 140 may be arranged between the channel 130 and the gate electrode 150.

The substrate 110 may be an insulating substrate or may be a semiconductor substrate with an insulating layer formed on its surface. The semiconductor substrate may include, for example, Si, Ge, SiGe, or a III-V group semiconductor material. The substrate 110 may be, for example, a silicon substrate with a silicon oxide formed on its surface, However, example embodiments of the disclosure are not limited thereto.

An A-A cross-section may refer to a first cross-section taken across from the source electrode 121 to the drain electrode 122 (in the X direction) in a direction perpendicular to the substrate 110 (in the Z direction). A B-B cross-section may refer to a second cross-section taken across between the source electrode 121 and the drain electrode 122 (in the Y direction) in a direction perpendicular to the substrate 110 (in the Z direction). Here, because the substrate 110 may not be a perfect plane, the vertical direction may include not only a substantially vertical direction but also an approximately vertical direction. Herein, the definitions of the A-A cross-section and the B-B cross-section described above will be used in common.

Referring to FIG. 2, the channel 130 may include a plurality of channel layers 131, 132, and 133 arranged apart from each other in a direction away from the substrate 110. The plurality of channel layers 131, 132, and 133 may have a sheet-type structure. For example, each of the plurality of channel layers 131, 132, and 133 may have a thickness greater than about 0 nm and less than or equal to about 20 nm, less than or equal to about 10 nm, or less than or equal to about 5 nm. The distance between the source electrode 121 and the drain electrode 122 may be, for example, greater than about 0 nm and less than or equal to about 100 nm, less than or equal to about 50 nm, or less than or equal to about 20 nm.

The channel 130 may be arranged between the source electrode 121 and the drain electrode 122 and thus may function as a path through which a current flows between the source electrode 121 and the drain electrode 122. The channel 130 may directly contact the source electrode 121 and the drain electrode 122. However, the channel 130 is not limited thereto, and the channel 130 may also be connected to the source electrode 121 and the drain electrode 122 through another medium. The channel 130 may have a structure in which both end portions E thereof are buried in the source electrode 121 and the drain electrode 122. That is, the plurality of channel layers 131, 132, and 133 may have a structure in which both end portions thereof are buried in the source electrode 121 and the drain electrode 122. However, example embodiments of the disclosure are not limited thereto, and the channel 130 may have a structure in which the plurality of channel layers 131, 132, and 133 may contact the source electrode 121 and the drain electrode 122 without being buried in the source electrode 121 and the drain electrode 122.

The plurality of channel layers 131, 132, and 133 may include, for example, a first channel layer 131, a second channel layer 132, and a third channel layer 133. In FIG. 2, three channel layers are illustrated. However, example embodiments of the disclosure are not limited thereto. The channel 130 may include a two-dimensional material. The two-dimensional material may include graphene, black phosphorus, phosphorene, amorphous boron nitride (a-BN), or transition metal dichalcogenide (TMD). The TMD may include a metal element selected from Mo, W, Nb, V, Ta, Ti, Zr, Hf, Tc, Re, Cu, Ga, In, Sn, Ge, and Pb and a chalcogen element selected from S, Se, and Te. The TMD may be represented as, for example, MX₂, where M denotes transition metal and X denotes a chalcogen element. For example, the TMD may include at least one of MoS₂, MoSe₂, MoTe₂, WS₂, WSe₂, WTe₂, ZrS₂, ZrSe₂, HfS₂, HfSe₂, NbSe₂, or ReSe₂. Alternatively, the TMD may not be represented as MX₂. In this case, for example, the TMD may include CuS that is a compound of Cu that is a transition metal and S that is a chalcogen element. However, the materials mentioned above are just examples, and other materials may be used as the TMD material.

The use of a two-dimensional material in the channel 130 may be to implement a short channel length when the semiconductor device 100 is applied to a field effect transistor. The channel length may refer to the length of the channel 130 in a direction in which the source electrode 121 and the drain electrode 122 are spaced apart from each other. Recently, the channel length has gradually decreased according to the trend of miniaturization of electronic apparatuses. It is known that problems due to the short channel effect are caused as the channel length decreases. In order to reduce or prevent this and/or effectively reduce the channel length, it may be advantageous to reduce the thickness of the channel 130. In other words, as the length of the channel 130 decreases, the minimum channel length that is implementable may decrease.

The two-dimensional material may have relatively good electrical properties and/or may maintain relatively high mobility without significantly changing its characteristics even when its thickness decreases to the nanoscale. The two-dimensional material may have a monolayer or multilayer structure. Each layer constituting the two-dimensional material may have an atomic-level thickness. The thickness of the channel 130 may be greater than about 0 nm and less than or equal to about 10 nm, less than or equal to about 5 nm, or less than or equal to about 3 nm. The thickness of the channel 130 is not limited thereto and may be smaller. The length of the channel 130, that is, the length of the channel 130 in a direction in which the source electrode 121 and the drain electrode 122 are spaced apart from each other, may be greater than about 0 nm and less than or equal to about 5 nm, less than or equal to about 4 nm, or less than or equal to about 3 nm. This is just an example and example embodiments of the disclosure are not limited thereto. As the thickness of the channel 130 decreases, the length of the channel 130 may decrease. In other words, as the thickness of the channel 130 decreases, a short channel effect may be suppressed, and thus it becomes possible to implement the channel 130 of a shorter length.

The source electrode 121 and the drain electrode 122 may include a metal material having electrical conductivity. For example, the source electrode 121 and the drain electrode 122 may include metal, such as magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), bismuth (Bi), or any alloy thereof.

Moreover, the gate insulating layer 140 may be arranged on the channel 130. The gate insulating layer 140 may include a high-k (high-dielectric) material or a ferroelectric material. The high-k material may refer to a dielectric constant higher than the dielectric constant of silicon oxide. The high-k material may include oxide including at least one of Ca, Sr, Ba, Sc, Y, La, Ti, Hf, Zr, Nb, Ta, Ce, Pr, Nd, Gd, Dy, Yb, or Lu. The ferroelectric material may have a non-centrosymmetric charge distribution in a unit cell in a crystallized material structure and thus may have a spontaneous electric dipole, that is, a spontaneous polarization. Thus, the ferroelectric material may have a remnant polarization due to a dipole even in the absence of an external electric field. Also, the direction of the polarization may be switched in units of domains by an external electric field. The ferroelectric material may include, for example, oxide of at least one selected from Hf, Si, Al, Zr, Y, La, Gd, and Sr. However, this is just an example. In some example embodiments, the ferroelectric material may further include a dopant.

The ferroelectric material may have, for example, at least one structure among a fluorite structure, a perovskite structure, or a wurtzite structure. The ferroelectric material having a fluorite structure may include, for example, hafnium oxide (HfO). For example, the ferroelectric material may include hafnium oxide and dopant. The dopant may include, for example, at least one of zirconium (Zr), lanthanum (La), aluminum (Al), silicon (Si), or yttrium (Y). In some example embodiment, the ferroelectric material may include hafnium and zirconium in substantially equal element ratios (e.g., Hf_{0.5}Zr_{0.5}O₂) and may be additionally doped with at least one element among lanthanum (La), aluminum (Al), silicon (Si), yttrium (Y), or gadolinium (Gd) in a ratio less than 10 at%. Also, the ferroelectric material having a perovskite structure may include, for example, lead zirconate titanate (PZT). The ferroelectric material having a wurtzite structure may include, for example, zinc oxide (ZnO) or aluminum nitride (AIN).

The gate insulating layer 140 may include, for example, at least one of HfO₂, ZrO₂, CeO₂, Ta₂O₃, TiO₂, or HfZrO. The gate insulating layer 140 may have a monolayer structure as illustrated. However, example embodiments of the disclosure are not limited thereto and the gate insulating layer 140 may have a multilayer structure. For example, the gate insulating layer 140 may have a multilayer structure of ZrO₂/HfO₂/ZrO₂/HfO₂. The thickness of the gate insulating layer 140 may be greater than about 0 nm and less than or equal to about 5 nm. However, example embodiments of the disclosure are not limited thereto.

When the gate insulating layer 140 includes a ferroelectric material, the semiconductor device 100 may be applied, for example, as a logic device or a memory device. When the gate insulating layer 140 includes a ferroelectric material, because a subthreshold swing (SS) may be reduced by a negative capacitance effect, the performance of the semiconductor device 100 may be improved while reducing the size of the semiconductor device 100.

The gate insulating layer 140 may have a multilayer structure including a high-k material and a ferroelectric material. Because the gate insulating layer 140 includes a charge trapping layer such as silicon nitride, the semiconductor device 100 may operate as a memory transistor having memory characteristics.

The gate insulating layer 140 may include a first gate insulating layer 141 and a second gate insulating layer 142. The first gate insulating layer 141 may be arranged between adjacent channel layers 131, 132, and 133 and may have a hollow closed cross-sectional structure. The second gate insulating layer 142 may be arranged at the uppermost layer and may include a bottom portion 142a contacting the third channel layer 133, a first side surface portion 142b contacting the side surface of the source electrode 121, an upper surface portion 142c contacting the upper surface of the source electrode 121, and a second side surface portion 142d contacting the side surface of the drain electrode 122. The upper surface portion 142c may be a surface facing the source electrode 121 in the vertical (up/down) direction (Z direction). In other words, the upper surface portion 142c may be a surface overlapping the source electrode 121 in the vertical direction. Herein, the vertical direction may refer to a direction (Z direction) perpendicular to the substrate 110. The upper surface of the second side surface portion 142d may be located at the same height as the upper surface of the drain electrode 122.

In the A-A cross-section, the second gate insulating layer 142 may have an asymmetrical structure with respect to a center plane (Y-Z plane) between the source electrode 121 and the drain electrode 122. The second gate insulating layer 142 may include an area facing the source electrode 121 in the vertical direction in an area adjacent to the source electrode 121 but may not include an area facing the drain electrode 122 in the vertical direction in an area adjacent to the drain electrode 122. FIG. 2 illustrates a structure in which the second gate insulating layer 142 does not include an area facing the drain electrode 122 in the vertical direction. In some example embodiments, however, an area facing the drain electrode 122 in the vertical direction may be arranged to have a smaller area than an area facing the source electrode 121 in the vertical direction.

The gate electrode 150 may be arranged on the gate insulating layer 140. The gate electrode 150 may include a metal material or conductive oxide. The metal material may include, for example, at least one selected from among Au, Ti, TiN, TaN, W, Mo, WN, Pt, and Ni. The conductive oxide may include, for example, indium tin oxide (ITO) or indium zinc oxide (IZO). The gate electrode 150 may include polysilicon or monocrystalline silicon. The gate electrode 150 may include the same material as the source electrode 121 and the drain electrode 122. However, example embodiments of the disclosure are not limited thereto, and the gate electrode 150 may include a different material than the source electrode 121 and the drain electrode 122.

The gate electrode 150 may include a first gate electrode 151 and a second gate electrode 152. The first gate electrode 151 may be arranged on the first gate insulating layer 141, and the second gate electrode 152 may be arranged on the second gate insulating layer 142. The first gate electrode 151 may be arranged on the inner side of the first gate insulating layer 141 having a hollow cross-sectional structure. The second gate electrode 152 may be arranged over the second gate insulating layer 142 and may include a first portion 152a between the source electrode 121 and the drain electrode 122, and a second portion 152b over the source electrode 121. The second portion 152b may be arranged to face the source electrode 121 in the vertical direction. In other words, the second portion 152b may be arranged to overlap the source electrode 121 in the vertical direction. Herein, an area in which the second gate electrode 152 overlaps the source electrode 121 in the vertical direction may be referred to as an overlap area. The second gate electrode 152 may include an overlap area facing the source electrode 121 in the vertical direction in an area adjacent to the source electrode 121 but may not include an area facing the drain electrode 122 in the vertical direction in an area adjacent to the drain electrode 122. FIG. 2 illustrates a structure in which the second gate electrode 152 does not include an area facing the drain electrode 122 in the vertical direction. In some example embodiments, however, an area facing the drain electrode 122 in the vertical direction may be arranged to have a smaller area than an area facing the source electrode 121 in the vertical direction.

The gate electrode 150 may include a metal material or conductive oxide. Here, the metal material may include, for example, at least one selected from among Au, Ti, TiN, TaN, W, Mo, WN, Pt, and Ni. The conductive oxide may include, for example, indium tin oxide (ITO) or indium zinc oxide (IZO). In some example embodiments, the gate electrode 150 may include the same material as the source electrode 121 and the drain electrode 122.

The semiconductor device 100 according to an example embodiment may use a two-dimensional semiconductor material as a channel material to reduce a short channel effect and implement a short channel length. The short channel effect may refer to a performance limit that appears when the channel length becomes short, and may be, for example, phenomena such as threshold voltage variation, carrier velocity saturation, and/or deterioration of subthreshold characteristics. It is known that the short channel effect is related to the channel thickness. As the channel thickness decreases, the minimum channel length that is implementable may decrease. Thus, when attempting to implement an ultra-small transistor to increase the degree of integration, the channel length may be effectively reduced by reducing the channel thickness. Also, the semiconductor device 100 according to an example embodiment may reduce the contact resistance by electrically doping the source area and may reduce the leakage current by excluding electrical doping from the drain area.

Referring to FIG. 3, the gate insulating layer 140 may have a hollow closed cross-sectional structure in the B-B cross-section. The gate electrode 150 may be arranged to surround the entire surface of the channel 130. As such, the semiconductor device 100 according to an example embodiment may have a gate-all-around structure.

In the semiconductor device 100 according to an example embodiment, the plurality of channel layers 131, 132, and 133 may have a multi-bridge structure in which both sides thereof contact the source electrode 121 and the drain electrode 122 and are stacked apart from each other in a direction away from the substrate 110. The channel having the multi-bridge structure may reduce the short channel effect and may reduce the area occupied by the source/drain and thus may be advantageous for higher integration. Also, because the semiconductor device 100 may maintain a relatively uniform source/drain junction capacitance regardless of the position of the channel, the semiconductor device 100 may be applied as a relatively high-speed and/or relatively high-reliability device. In FIG. 2, the multi-bridge channel is illustrated as three channels. However, this is just an example and example embodiments of the disclosure are not limited thereto and the semiconductor device 100 according to an example embodiment may include four or more stacked channel layers.

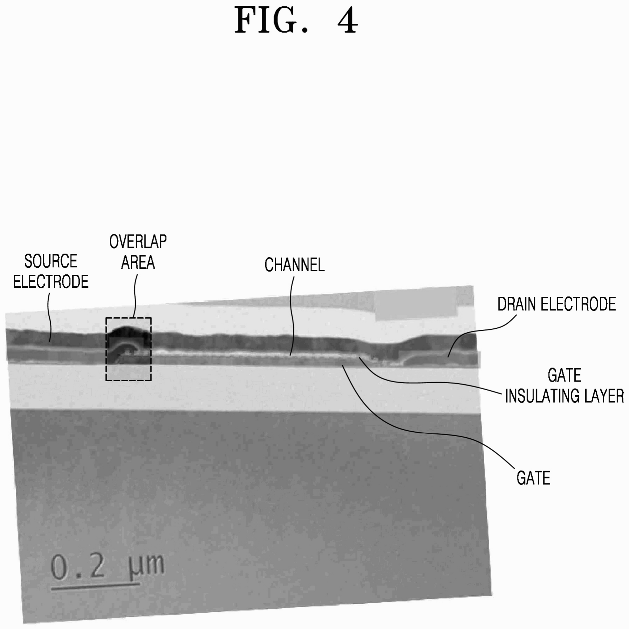

FIG. 4 illustrates a transmission electron microscope (TEM) image of a semiconductor device according to an example embodiment. FIG. 4 illustrates an example in which a semiconductor device is applied to a planar field effect transistor and shows that there is an overlap area in which a gate electrode and a source electrode overlap each other in the vertical direction.

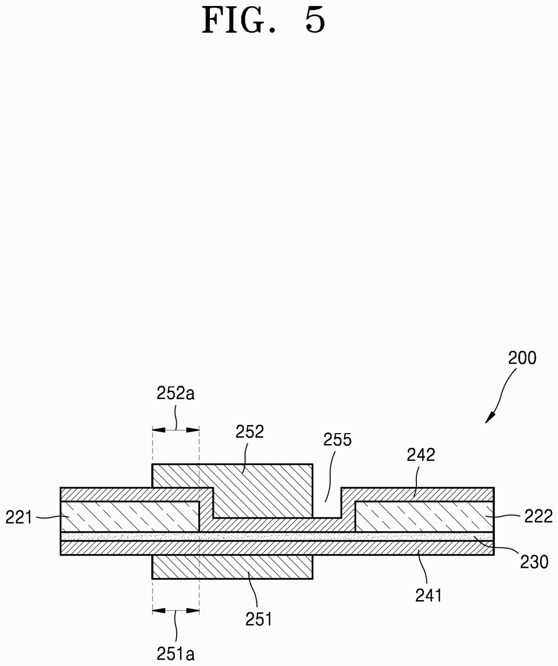

FIG. 5 illustrates a cross-sectional view of a semiconductor device according to an example embodiment. A semiconductor device 200 may be a planar field effect transistor having a dual-gate structure. The semiconductor device 200 may include a channel 230 including a two-dimensional material, a source electrode 221 and a drain electrode 222 arranged apart from each other on the channel 230, a lower gate electrode 251 arranged under the channel 230, an upper gate electrode 252 arranged over the channel 230, a lower gate insulating layer 241 arranged between the channel 230 and the lower gate electrode 251, and an upper gate insulating layer 242 arranged between the channel 230 and the upper gate electrode 252. As such, the semiconductor device 200 may have a dual-gate structure in which the lower and upper gate electrodes 251 and 252 are arranged over and under the channel 230, respectively. The lower gate electrode 251 may include a first overlap area 251a facing the source electrode 221 in the vertical direction, and the upper gate electrode 252 may include a second overlap area 252a facing the source electrode 221 in the vertical direction.

Moreover, the lower gate electrode 251 may not include an area facing the drain electrode 222 in the vertical direction, and the upper gate electrode 252 may not include an area facing the drain electrode 222 in the vertical direction. As such, the lower gate electrode 251 and the upper gate electrode 252 may have an asymmetrical structure with respect to the source electrode 221 and the drain electrode 222. There may be a separation space 255 between the upper gate electrode 252 and a portion of the upper gate insulating layer 242 on the drain area 222. However, the upper gate electrode 252 may also be arranged without the separation space 255 from the portion of the upper gate insulating layer 242 on the drain area 222.

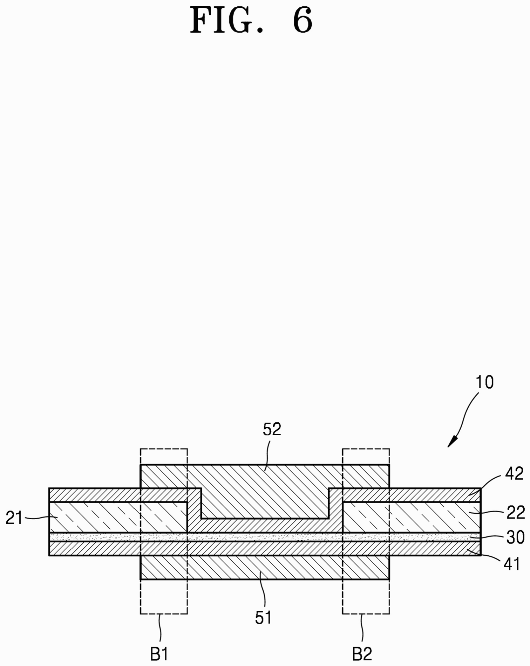

FIG. 6 illustrates a semiconductor device according to a comparative example.

A semiconductor device 10 according to a comparative example may include a channel 30 including a two-dimensional material, a source electrode 21 and a drain electrode 22 arranged apart from each other on the channel 30, a lower gate electrode 51 arranged under the channel 30, an upper gate electrode 52 arranged over the channel 30, a lower gate insulating layer 41 arranged between the channel 30 and the lower gate electrode 51, and an upper gate insulating layer 42 arranged between the channel 30 and the upper gate electrode 52. In the semiconductor device 10, each of the lower gate electrode 51 and the upper gate electrode 52 may include a first overlap area B1 facing the source electrode 21 in the vertical direction, and each of the lower gate electrode 51 and the upper gate electrode 52 may include a second overlap area B2 facing the drain electrode 22 in the vertical direction. As such, in the comparative example, the lower gate electrode 51 may have a symmetrical structure with respect to the source electrode 21 and the drain electrode 22, and the upper gate electrode 52 may have a symmetrical structure with respect to the source electrode 21 and the drain electrode 22.

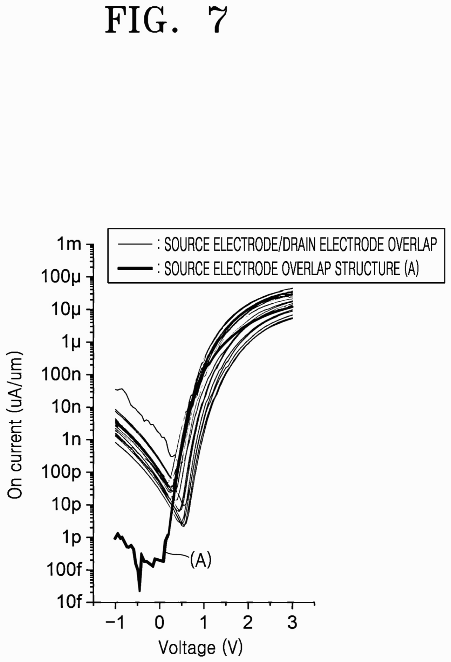

FIG. 7 illustrates a V_{g}-I_{d} graph of a semiconductor device 200 according to an example embodiment and a semiconductor device 10 according to a comparative example. Here, I_{d} denotes a drain current and V_{g} denotes a gate voltage. Graph A includes an I_{d}-V_{g} curve of the semiconductor device 200 according to an example embodiment and I_{d}-V_{g} curves of the semiconductor device 10 according to a comparative example. It may be seen that, in the semiconductor device 10 according to a comparative example, the contact resistance is low because I_{d} increases when V_{g} is applied, whereas the leakage current is relatively large because a relatively high current flows even when V_{g} is 0 or less. It may be seen that, in the semiconductor device 200 according to an example embodiment, the contact resistance is low because I_{d} increases when V_{g} is applied, whereas the leakage current is relatively small because a relatively low current flows when V_{g} is 0 or less. As such, in the semiconductor device 200 according to an example embodiment, because the gate electrode 251/252 includes an overlap area 251a/252a with respect to the source electrode 221, the contact resistance may decrease and thus the on-current may increase, and because the drain electrode 222 does not include an overlap area, the leakage current may decrease.

Hereinafter, the operational effects of the semiconductor device according to an example embodiment will be described.

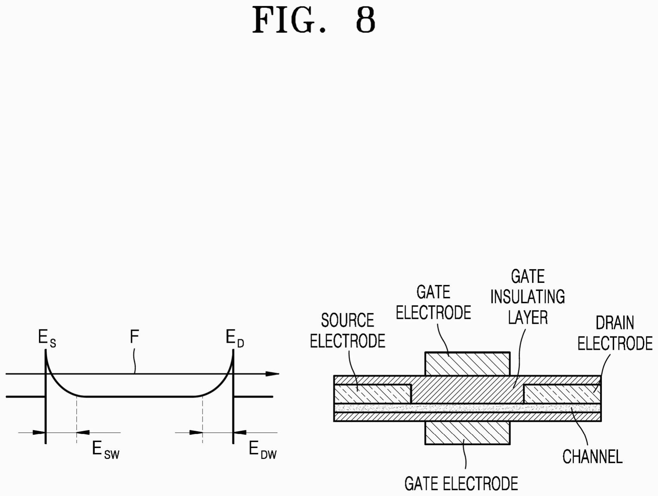

FIG. 8 schematically illustrates a semiconductor device having a dual-gate structure and having no overlap area with a source electrode and an off-state energy band diagram corresponding thereto. Here, E_{S} denotes the energy of the channel connected to the source electrode, E_{D} denotes the energy of the channel connected to the drain electrode, E_{SW} denotes the width of an energy barrier formed when the source electrode and the channel meet each other, E_{DW} denotes the width of an energy barrier formed when the drain electrode and the channel meet each other, and F denotes a current flow. Referring to FIG. 8, when no voltage is applied to the drain electrode, no current flows due to the energy barrier.

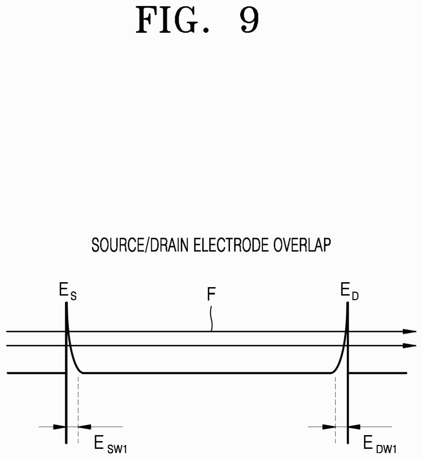

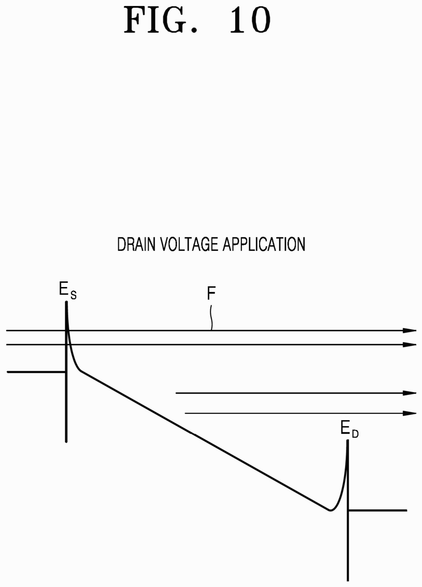

FIG. 9 schematically illustrates an energy band diagram in a case where a symmetrical overlap area is arranged on both sides of a source electrode and a drain electrode. An overlap area between the gate electrode and the source electrode may be arranged, and an overlap area between the gate electrode and the drain electrode may be arranged. In this case, the energy barrier width (E_{SW1}) of the source electrode area and the channel and the energy barrier width (E_{DW1}) of the drain electrode area and the channel may be reduced. FIG. 10 schematically illustrates an energy band diagram of the on state when no voltage is applied to the source electrode and a voltage is applied to the drain electrode. When a voltage is applied to the drain electrode, because the drain electrode energy (E_{D}) is reduced, a current may flow from the source electrode to the drain electrode and the semiconductor device may be turned on.

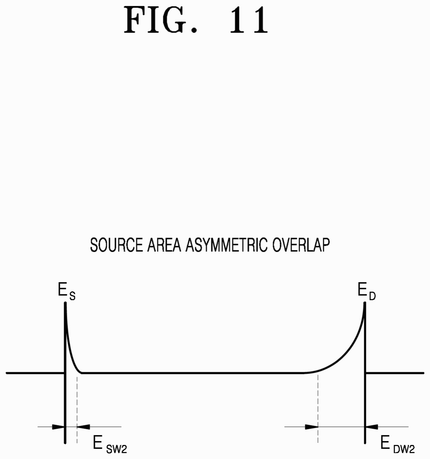

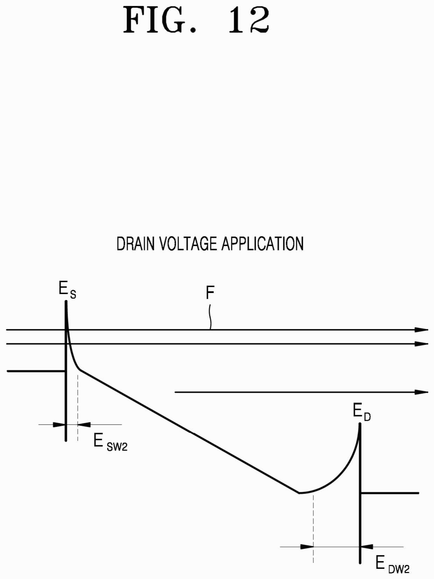

FIG. 11 schematically illustrates an energy band diagram in a case where an overlap area is arranged in a source electrode area. In this case, the gate electrode may include an overlap area on the source electrode side and may not include an overlap area on the drain electrode side. In this case, the energy barrier width (E_{SW2}) of the source electrode area and the channel may be smaller than the energy barrier width (E_{DW2}) of the drain electrode area and the channel. FIG. 12 schematically illustrates an energy band diagram in a case where a drain voltage is applied in a structure in which an overlap area is arranged in a source electrode area. In this case, because the drain electrode energy band width (E_{DW2}) is large and a drain voltage is applied, E_{D} may decrease. As E_{D} decreases, the current amount may increase, and as E_{DW2} increases, the leakage current may decrease.

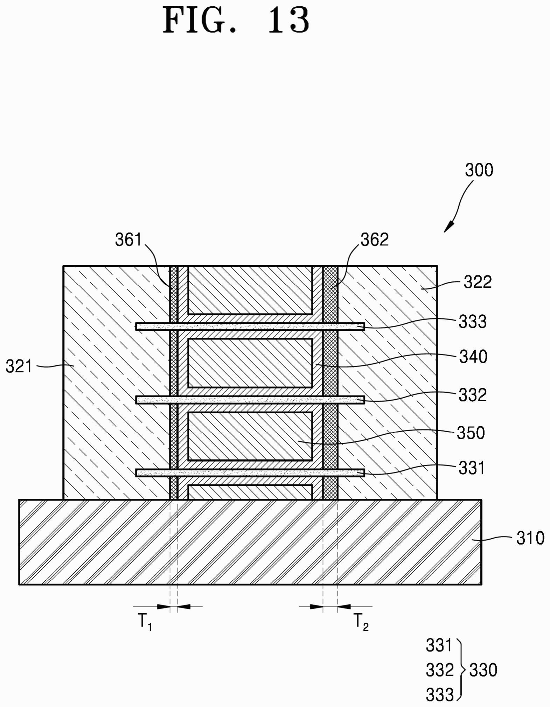

FIG. 13 is a diagram illustrating a semiconductor device 300 according to another example embodiment.

The semiconductor device 300 may include a substrate 310, a source electrode 321 arranged on the substrate 310, a drain electrode 322 arranged apart from the source electrode 321, a channel 330 connected between the source electrode 321 and the drain electrode 322, a gate insulating layer 340 arranged on the channel 330, and a gate electrode 350 arranged on the gate insulating layer 340. The substrate 310, the source electrode 321, and the drain electrode 322 may be substantially the same as those described above with reference to FIG. 1, and thus, redundant descriptions thereof will be omitted for conciseness.

The channel 330 may include a plurality of channel layers 331, 332, and 333 including a two-dimensional material, and the plurality of channel layers 331, 332, and 333 may be arranged apart from each other in a direction away from the substrate 310. The plurality of channel layers 331, 332, and 333 may include a first channel layer 331, a second channel layer 332, and a third channel layer 333. In the present example embodiment, the gate electrode 350 may have a symmetrical structure with respect to the source electrode 321 and the drain electrode 322. For example, the gate electrode 350 may not include an overlap area facing the source electrode 321 in the vertical direction. Spacers 361 and 362 may be arranged between the plurality of channel layers 331, 332, and 333 to support corresponding pairs of the plurality of channel layers 331, 332, and 333 in the vertical direction. The spacers 361 and 362 may include a first spacer 361 arranged adjacent to the source electrode 321 and a second spacer 362 arranged adjacent to the drain electrode 322. The first spacer 361 and the second spacer 362 may include a dielectric material. The first spacer 361 and the second spacer 362 may include, for example, at least one of SiO₂, SiN, or a-BN. The first spacer 361 may have an asymmetrical structure with the second spacer 362. For example, a thickness T1 of the first spacer 361 may be less than a thickness T2 of the second spacer 362. In the present example embodiment, because the first spacer 361 and the second spacer 362 have an asymmetrical structure, electrical doping may be implemented. Because the thickness T1 of the first spacer 361 is less than the thickness T2 of the second spacer 362, the energy band width of the source electrode 321 may be less than the energy band width of the drain electrode 322 and thus the contact resistance may be reduced.

The first channel layer 331, the second channel layer 332, and the third channel layer 333 may have a structure in which both end portions thereof are buried in the source electrode 321 and the drain electrode 322. As such, when the first channel layer 331, the second channel layer 332, and the third channel layer 333 have a buried structure, because the area in which each of the channel layers 331, 332, and 333 contacts the source electrode 321 and the drain electrode 322 may be expanded, the contact resistance may be reduced and the on-current may be increased.

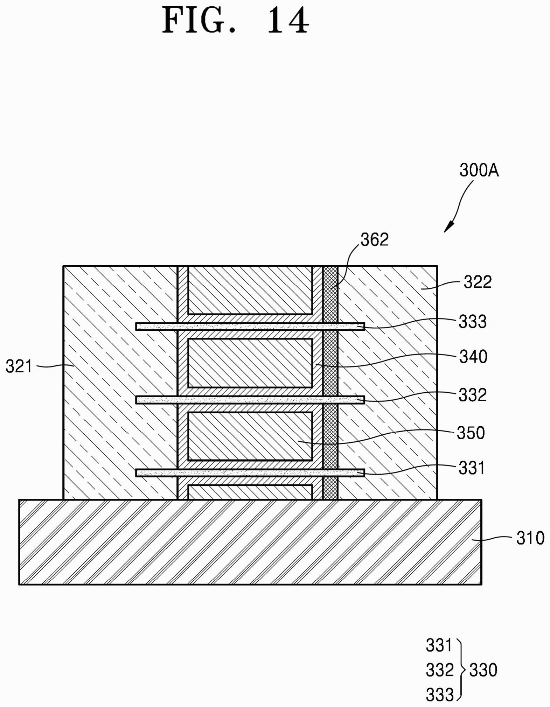

FIG. 14 illustrates an example in which a spacer structure is modified when compared to FIG. 13. In FIG. 14, components denoted by the same reference numbers as those in FIG. 13 may be the same as those described above with reference to FIG. 13, and thus, redundant descriptions thereof will be omitted and differences therefrom will be mainly described.

Referring to FIG. 14, in a semiconductor device 300A according to an example embodiment, no spacer may be arranged in an area adjacent to the source electrode 321, and a second spacer 362 may be arranged between the plurality of channel layers 331, 332, and 333 in an area adjacent to the drain electrode 322.

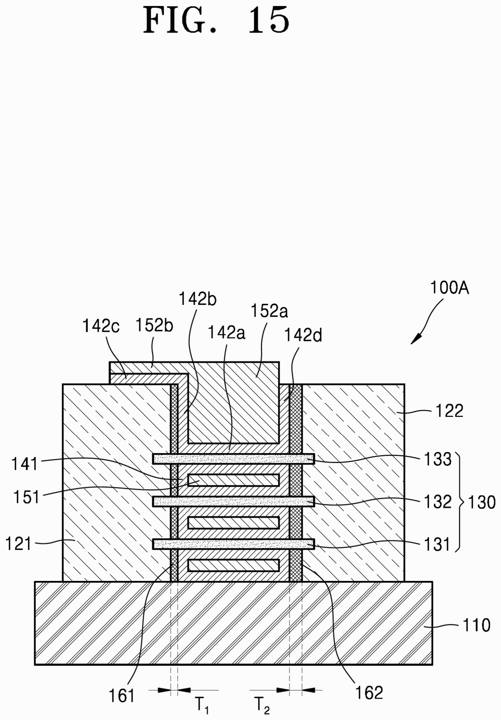

FIG. 15 illustrates an example in which a space is further included in the semiconductor device 100 illustrated in FIG. 1. Regarding FIG. 15, differences from FIG. 1 will be mainly described.

Referring to FIG. 15, in a semiconductor device 100A according to another example, a first spacer 161 may be arranged between the plurality of channel layers 131, 132, and 133 in an area adjacent to the source electrode 121, and a second spacer 162 may be arranged between the plurality of channel layers 131, 132, and 133 in an area adjacent to the drain electrode 122. The first spacer 161 may also be arranged under the first channel layer 131 and over the third channel layer 133. Also, the second spacer 162 may also be arranged under the first channel layer 131 and over the third channel layer 133. A thickness T1 of the first spacer 161 may be less than a thickness T2 of the second spacer 162. In the present example embodiment, the contact resistance may be reduced by the small thickness T1 of the first spacer 161 together with the overlap area between the gate electrode 150 and the source electrode 121.

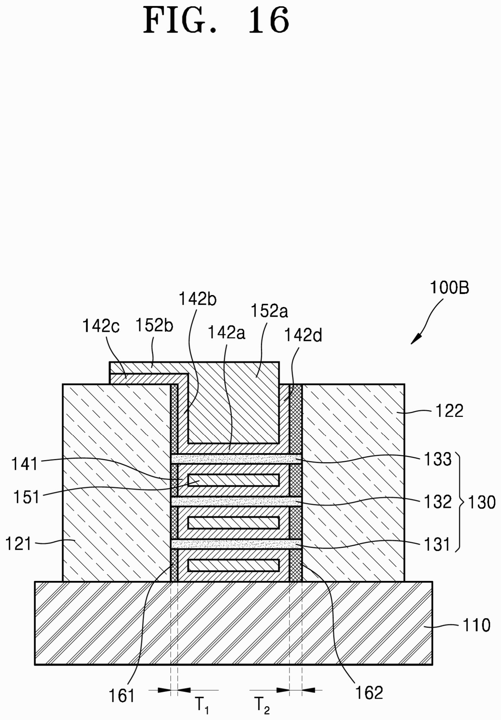

FIG. 16 illustrates an example in which a coupling structure of the plurality of channel layers 131, 132, and 133 is modified when compared to FIG. 15. Regarding FIG. 16, differences from FIG. 15 will be mainly described.

Referring to FIG. 16, in a semiconductor device 100B according to an example embodiment, a first channel layer 131, a second channel layer 132, and a third channel layer 133 may contact the source electrode 121 and the drain electrode 122 without a portion buried in the source electrode 121 and the drain electrode 122.

As described above, the semiconductor device 100/100A/100B/200/300/300A according to an example embodiment may have an asymmetrical structure with respect to the center plane between the source electrode 121/221/321 and the drain electrode 122/222/322, thus implementing electrical doping in the two-dimensional material channel. Thus, the contact resistance may be reduced and thus the on-current may be increased and the leakage current may be reduced.

Also, the semiconductor device 100 according to an example embodiment may have a gate-all-around structure in which the gate electrode surrounds four sides of the channel, thereby enabling more precise current control and/or achieving higher power efficiency. The semiconductor device according to an example embodiment may be applied to electronic apparatuses requiring or needing higher performance and/or lower power consumption, such as mobile phones, artificial intelligence (AI) apparatuses, 5G communication apparatuses, electronics, and Internet of Things (IoT) apparatuses.

The semiconductor device 100 according to an example embodiment may further increase the area in which the gate electrode and the channel contact each other. Therefore, the power consumption may be reduced and/or the performance may be improved.

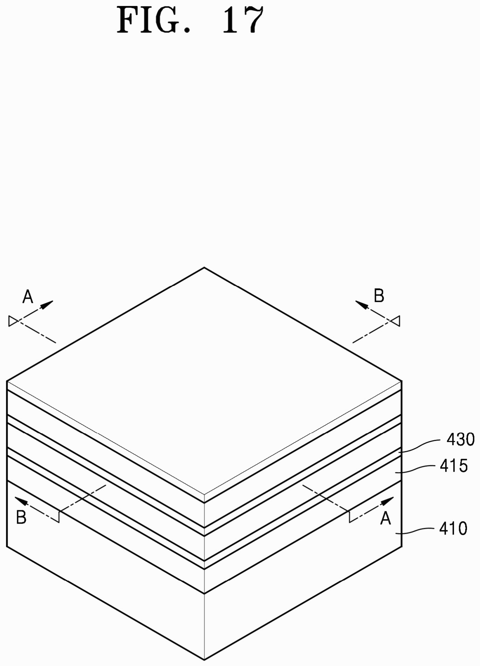

Next, a semiconductor device manufacturing method according to an example embodiment will be described with reference to FIGS. 17 to 25B.

Referring to FIG. 17, a sacrificial layer 415 and a channel 430 may be alternately stacked on a substrate 410. The substrate 410 may be an insulating substrate or may be a semiconductor substrate with an insulating layer formed on its surface. The semiconductor substrate may include, for example, Si, Ge, SiGe, or a III-V group semiconductor material. The substrate 410 may be, for example, a silicon substrate with a silicon oxide formed on its surface. However, example embodiments of the disclosure are not limited thereto. The sacrificial layer 415 may include materials that may be selectively removed depending on etching gases or etching solutions. The sacrificial layer 415 may include, for example, an inorganic material such as SiO₂, Al₂O₃, Si₃N₄, poly-Si, or SiGe or an organic material such as polymethyl methacrylate (PMMA) or polyrotaxane (PR).

The channel 430 may be formed by a chemical vapor deposition (CVD), metal organic chemical vapor deposition (MOCVD), or atomic layer deposition (ALD) process. The channel 430 may include, for example, a two-dimensional material. The two-dimensional material may include graphene, black phosphorus, phosphorene, or transition metal dichalcogenide (TMD). The two-dimensional material may be deposited with a thickness of several nanometers.

Manufacturing processes are respectively illustrated in an A-A cross-section (first cross-section) and a B-B cross-section (second cross-section) of FIG. 17.

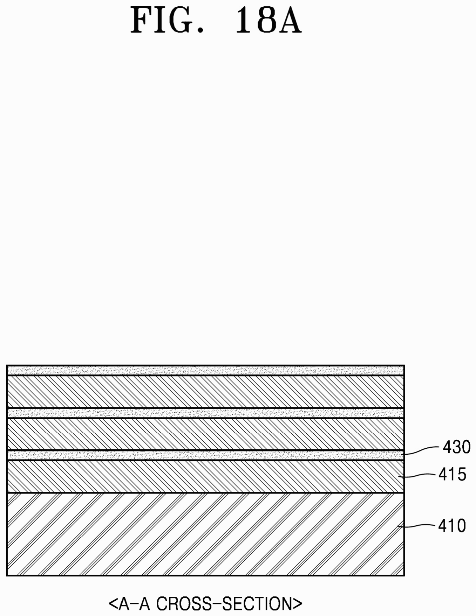

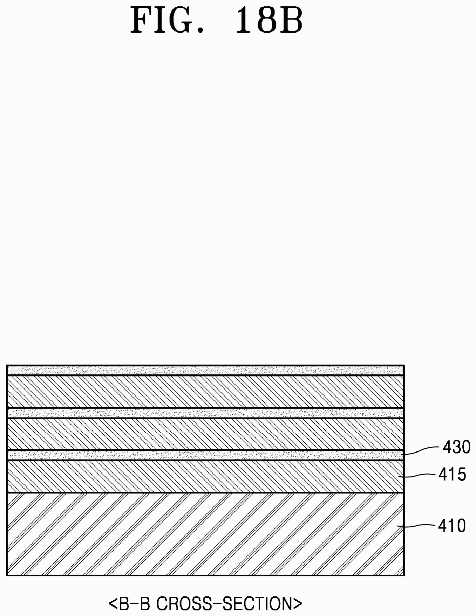

FIG. 18A illustrates a cross-sectional view taken along line A-A of FIG. 17, and FIG. 18B illustrates a cross-sectional view taken along line B-B of FIG. 17.

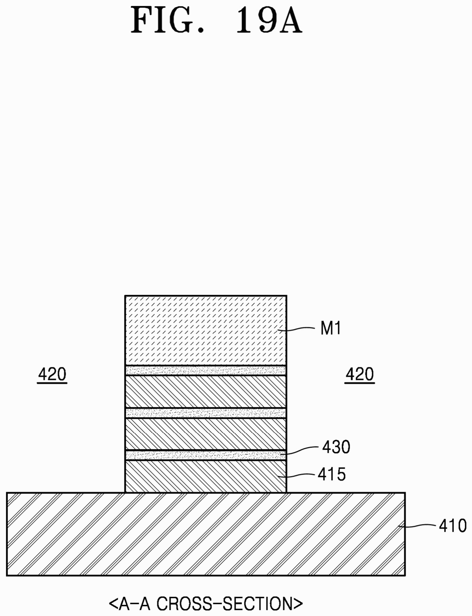

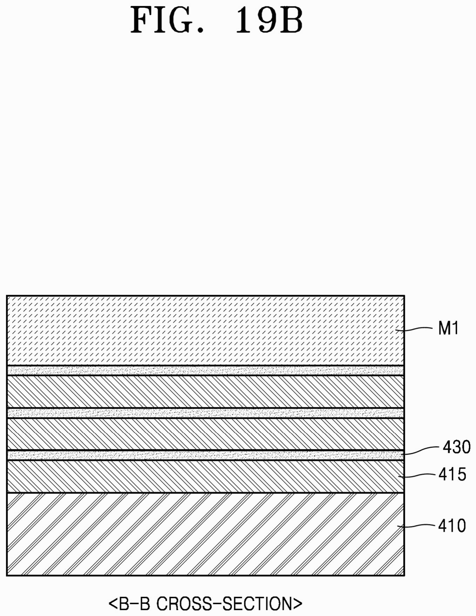

Referring to FIGS. 19A and 19B, a stack structure of the sacrificial layer 415 and the channel 430 may be patterned by using a first mask M1. The first mask M1 may have a pattern corresponding to a source electrode and a drain electrode. The stack structure may be patterned by removing a portion of the stack structure of the sacrificial layer 415 and the channel 430 by using the first mask M1. An electrode corresponding areas 420 may be formed on both sides of the patterned stack structure, respectively.

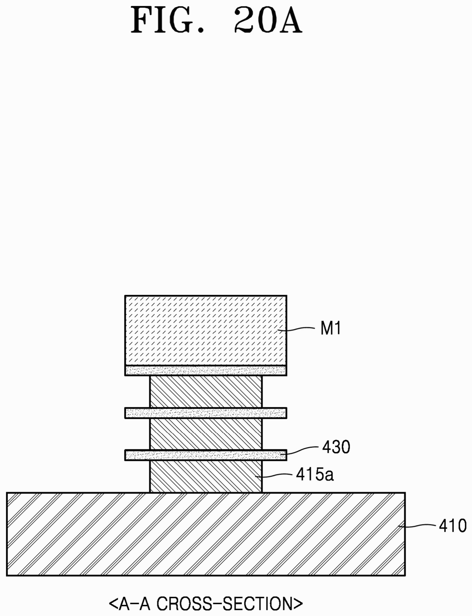

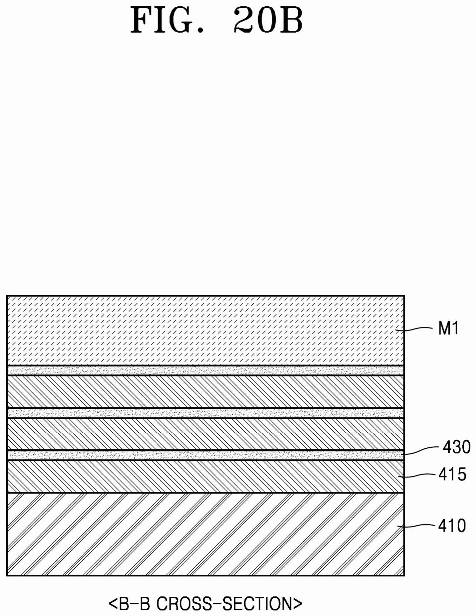

Referring to FIGS. 20A and 20B, a sacrificial layer 415a having a smaller width than the channel 430 may be formed by etching a portion of the sacrificial layer 415 in the A-A cross-section.

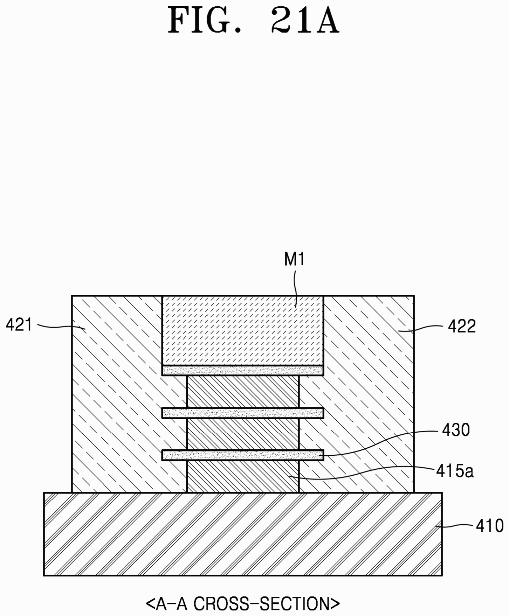

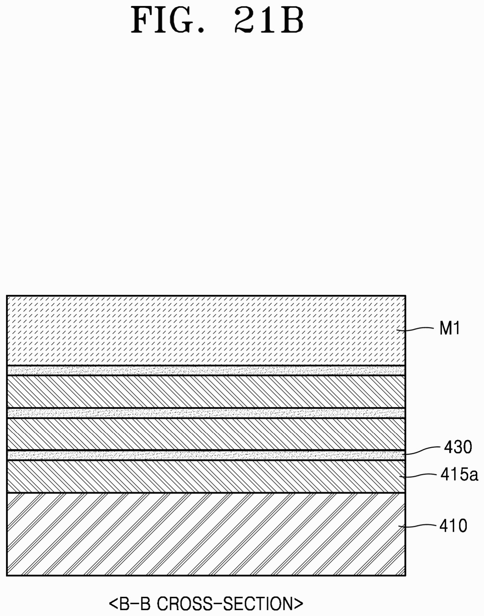

Referring to FIGS. 21A and 21B, a source electrode 421 and a drain electrode 422 may be formed in the electrode corresponding area 420. In the B-B cross-section, an electrode may not be formed by being blocked by the first mask M1.

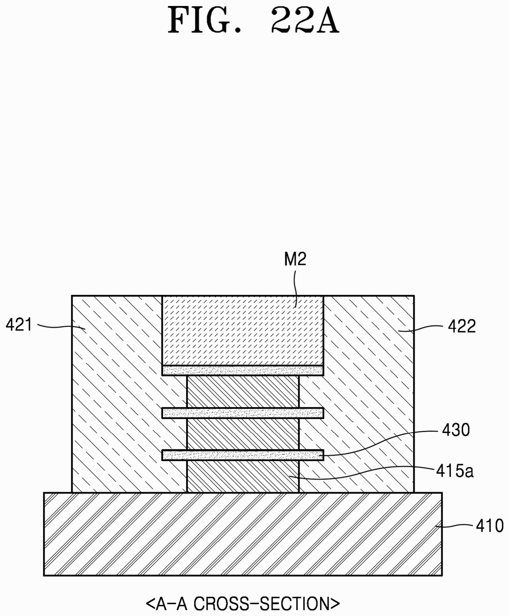

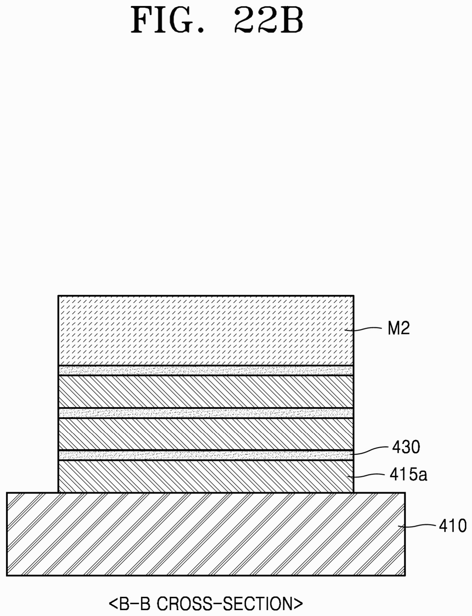

Referring to FIGS. 22A and 22B, the first mask M1 may be removed, and a second mask M2 may be used to etch both side surfaces of the stack structure of the sacrificial layer 415a and the channel 430 in the B-B cross-section. In this operation, the width of the channel 430 in the B-B cross-section may be defined.

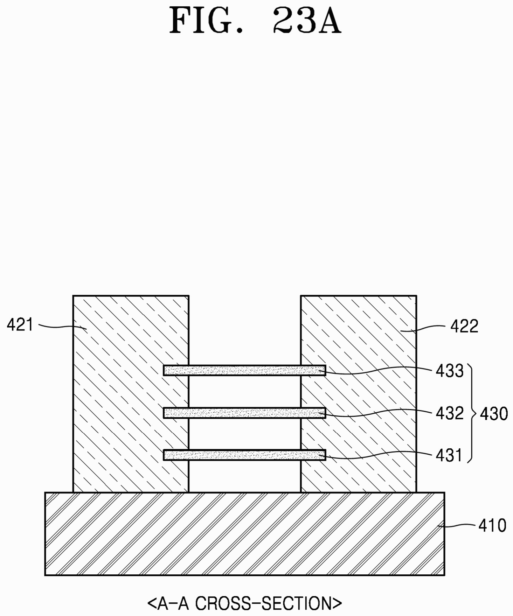

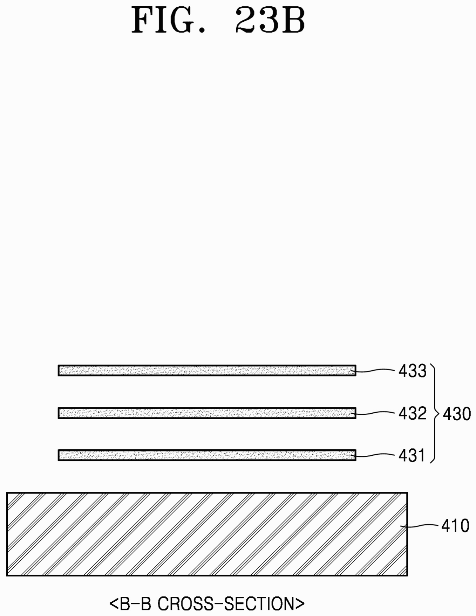

Referring to FIGS. 23A and 23B, an etching gas for selectively etching only the second mask M2 and the sacrificial layer 415a may be used to remove the second mask M2 and the sacrificial layer 415a and leave the channel 430. The channel 430 may be connected between the source electrode 221 and the drain electrode 222, and the channel 430 may be stacked in a multi-bridge form with channels spaced apart from each other. The channel 430 may include, for example, a first channel layer 431, a second channel layer 432, and a third channel layer 433. The first channel layer 431, the second channel layer 432, and the third channel layer 433 may be suspended between the source electrode 221 and the drain electrode 222.

When the channel 430 is formed of a two-dimensional material, it may be difficult to form the channel 430 because the channel 430 is very thin; however, by burying both end portions of the channel 430 in the source electrode 421 and the drain electrode 422, the two-dimensional material may be easily deposited thinly and/or the thin channel 430 may be stably supported.

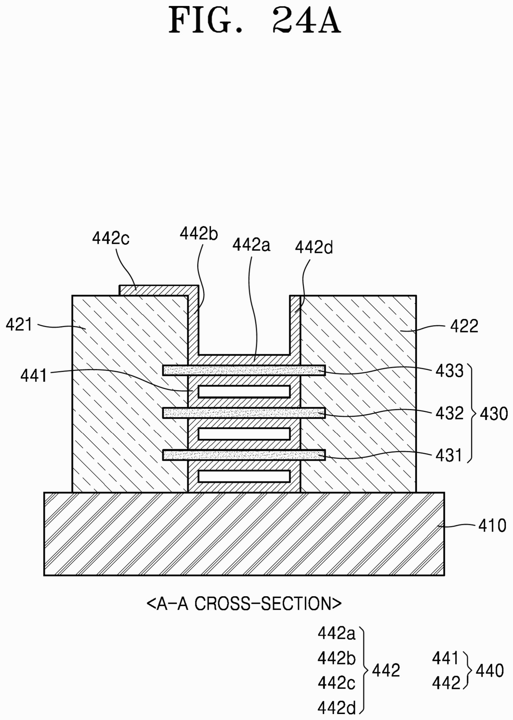

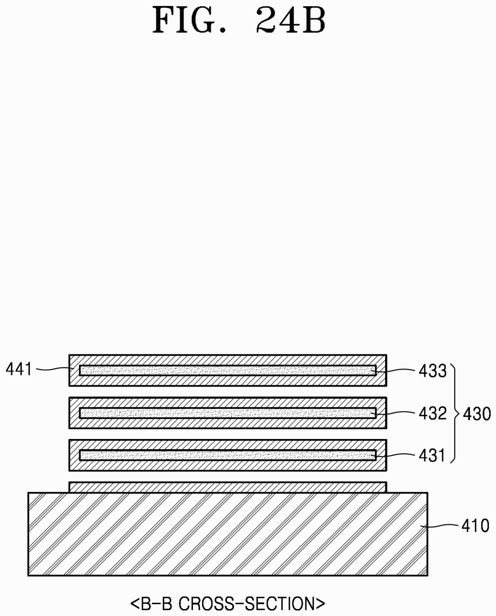

Referring to FIGS. 24A and 24B, a gate insulating layer 440 may be deposited on the channel 430. The gate insulating layer 440 may be formed by physical vapor deposition, CVD, or ALD. The gate insulating layer 440 may include a first gate insulating layer 441 located under the channel 430 and a second gate insulating layer 442 located over the channel 430. The gate insulating layer 440 may include at least one of a high-k material or a ferroelectric material. The first gate insulating layer 441 may have a hollow closed cross-sectional structure in the A-A cross-section and the B-B cross-section. The second gate insulating layer 442 may include a bottom portion 442a contacting the third channel layer 433, a first side surface portion 442b contacting the side surface of the source electrode 421, an upper surface portion 442c contacting the upper surface of the source electrode 421, and a second side surface portion 442d contacting the side surface of the drain electrode 422. The upper surface portion 442c may be a surface that faces the source electrode 421 in the vertical direction. In other words, the upper surface portion 442c may be a surface that overlaps the source electrode 421 in the vertical direction.

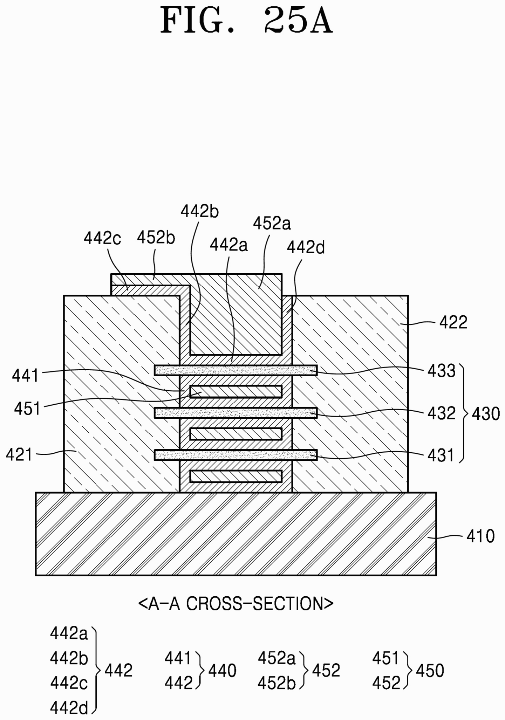

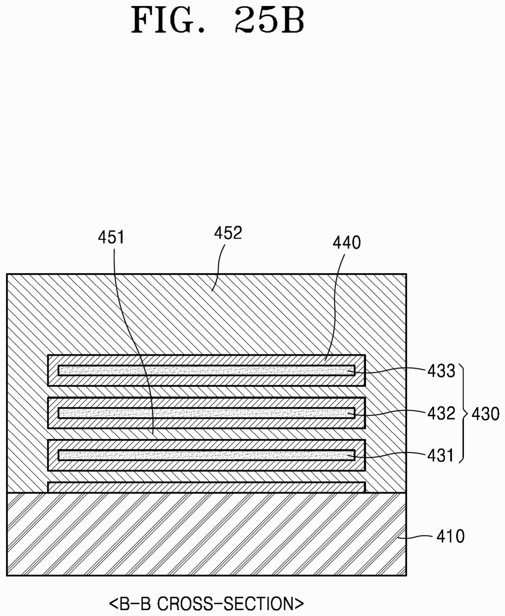

Referring to FIGS. 25A and 25B, a gate electrode 450 may be deposited on the gate insulating layer 440. The gate electrode 450 may be formed by physical vapor deposition, CVD, or ALD. The gate electrode 450 may include a first gate electrode 451 and a second gate electrode 452. The first gate electrode 451 may be arranged on the first gate insulating layer 441, and the second gate electrode 452 may be arranged on the second gate insulating layer 442. The first gate electrode 451 may be arranged on the inner side of the first gate insulating layer 441 having a hollow cross-sectional structure. The second gate electrode 452 may be arranged over the second gate insulating layer 442 and may include a first portion 452a between the source electrode 421 and the drain electrode 422, and a second portion 452b over the source electrode 421. The second portion 452b may be arranged to face the source electrode 421 in the vertical direction. In other words, the second portion 452b may be arranged to overlap the source electrode 421 in the vertical direction. The second gate electrode 452 may include an area facing the source electrode 421 in the vertical direction in an area adjacent to the source electrode 421 but may not include an area facing the drain electrode 422 in the vertical direction in an area adjacent to the drain electrode 422.

As described above, a semiconductor device having an asymmetrical structure may be manufactured according to the semiconductor device manufacturing process according to an example embodiment.

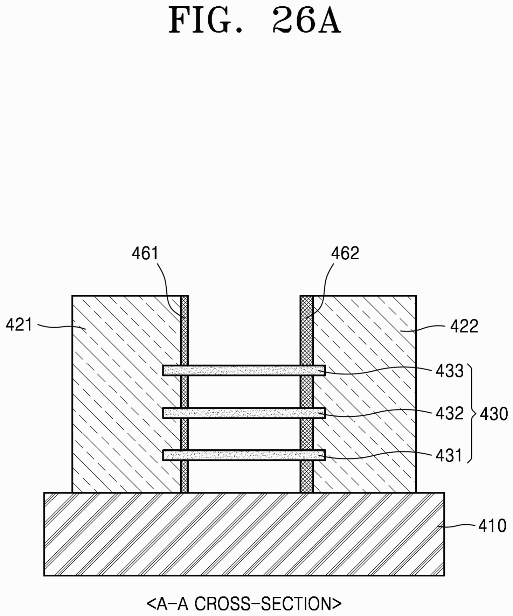

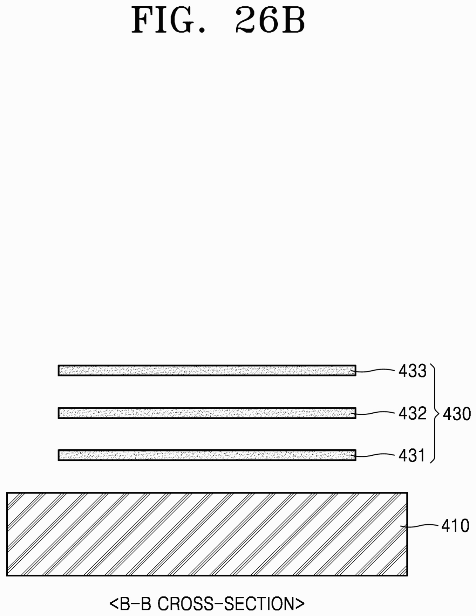

Next, FIGS. 26A and 26B illustrate a process of further forming a spacer. Following the process illustrated in FIGS. 23A and 23B, a first spacer 461 may be formed on the inner side of the source electrode 421, and a second spacer 462 may be formed on the inner side of the drain electrode 422. The thickness of the first spacer 461 may be different from the thickness of the second spacer 462. The thickness of the first spacer 461 may be less than the thickness of the second spacer 462. The first spacer 461 and the second spacer 462 may include at least one of SiO₂, SiN, or a-BN.

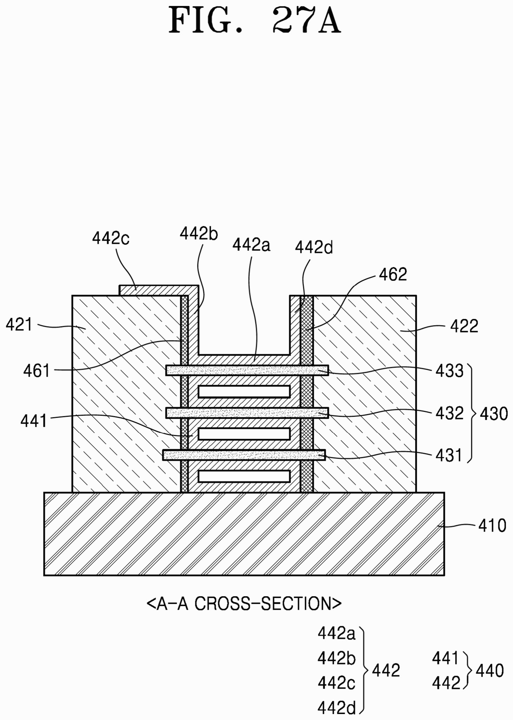

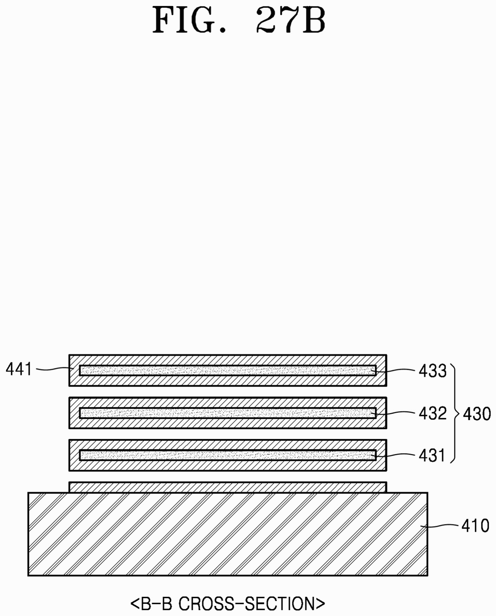

Referring to FIGS. 27A and 27B, a gate insulating layer 440 may be formed on the first spacer 461, the channel 430, and the second spacer 462. The gate insulating layer 440 may be the same as that described above with reference to FIGS. 24A and 24B, and thus, redundant descriptions thereof will be omitted for conciseness.

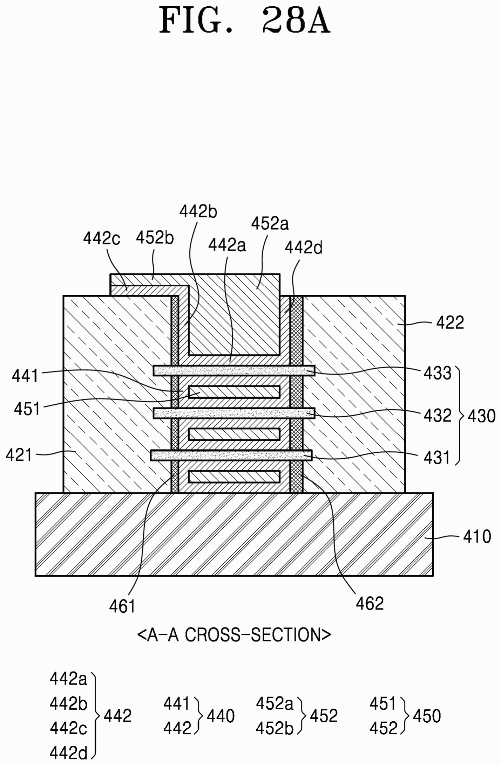

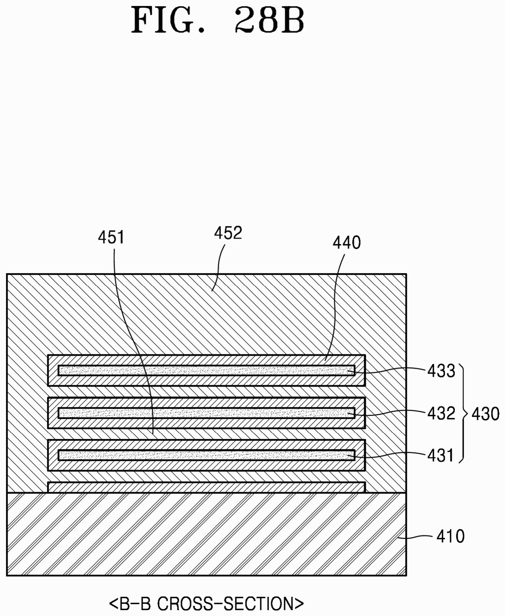

Referring to FIGS. 28A and 28B, a gate electrode 450 may be formed on the gate insulating layer 440. The gate electrode 450 may be the same as that described above with reference to FIGS. 25A and 25B, and thus, redundant descriptions thereof will be omitted for conciseness.

According to the above description, a semiconductor device including an asymmetrical spacer and an asymmetrical gate electrode may be manufactured.

The semiconductor devices 100/100A/100B/200/300 according to the above example embodiments may include a channel including a two-dimensional material, thus suppressing the short channel effect and effectively reducing the thickness and length of the channel. The semiconductor device manufacturing method according to the example embodiments may easily form a very thin channel with a thickness of several nm or less. The semiconductor devices 100/100A/100B/200/300 according to the example embodiments may include at least one of an asymmetrical gate electrode or an asymmetrical spacer to implement electrical doping in a channel including a two-dimensional material, thus reducing the contact resistance and reducing the leakage current.

The semiconductor device according to an example embodiment may have an ultra-small size and/or improved electrical performance and thus may be suitable for application to a relatively high-integration integrated circuit (IC) device.

The semiconductor device according to an example embodiment may constitute a transistor constituting a digital circuit or an analog circuit. In some example embodiments, the semiconductor device according to an example embodiment may be used as a relatively high-voltage transistor or a relatively low-voltage transistor. For example, the semiconductor device according to an example embodiment may constitute a relatively high-voltage transistor constituting a peripheral circuit of an electrically erasable and programmable read only memory (EEPROM) device or a flash memory device, which is a nonvolatile memory device that operates at a relatively high voltage. In some example embodiments, the semiconductor device according to an example embodiment may constitute a transistor included in an IC device for a liquid crystal display (LCD) that needs an operation voltage of 10 V or more, for example, an operation voltage of about 20 V to about 30 V, or in an IC chip or the like used in a plasma display panel (PDP) that needs an operation voltage of 100 V.

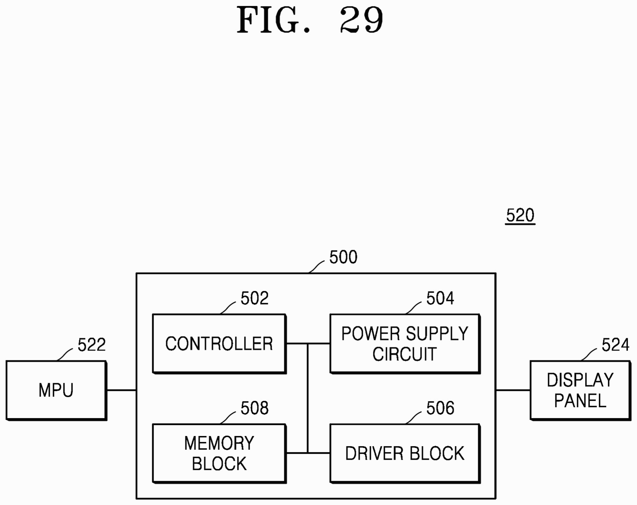

FIG. 29 is a schematic block diagram illustrating a display driver IC (DDI) 500 and a display apparatus 520 including the DDI 500 according to an example embodiment.

Referring to FIG. 29, the DDI 500 may include a controller 502, a power supply circuit 504, a driver block 506, and a memory block 508. The controller 502 may receive and decode a command applied from a main processing unit (MPU) 522 and control each of the blocks of the DDI 500 to implement an operation according to the command. The power supply circuit 504 may generate a driving voltage in response to the control by the controller 502. The driver block 506 may drive a display panel 524 by using the driving voltage generated by the power supply circuit 504 in response to the control by the controller 502. The display panel 524 may be an LCD panel or a PDP. The memory block 508 may be a block for temporarily storing commands input to the controller 502 or control signals output from the controller 502 or storing necessary or desired data and may include a memory such as RAM and/or ROM. The power supply circuit 504 and the driver block 506 may include the semiconductor devices according to the example embodiments described above with reference to FIGS. 1 to 28B.

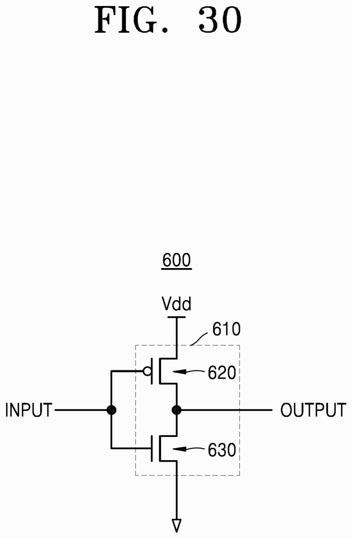

FIG. 30 is a circuit diagram of a CMOS inverter 600 according to an example embodiment.

The CMOS inverter 600 may include a CMOS transistor 610. The CMOS transistor 610 may include a PMOS transistor 620 and an NMOS transistor 630 connected between a power terminal Vdd and a ground terminal. The CMOS transistor 610 may include the semiconductor devices according to the example embodiments described above with reference to FIGS. 1 to 28B.

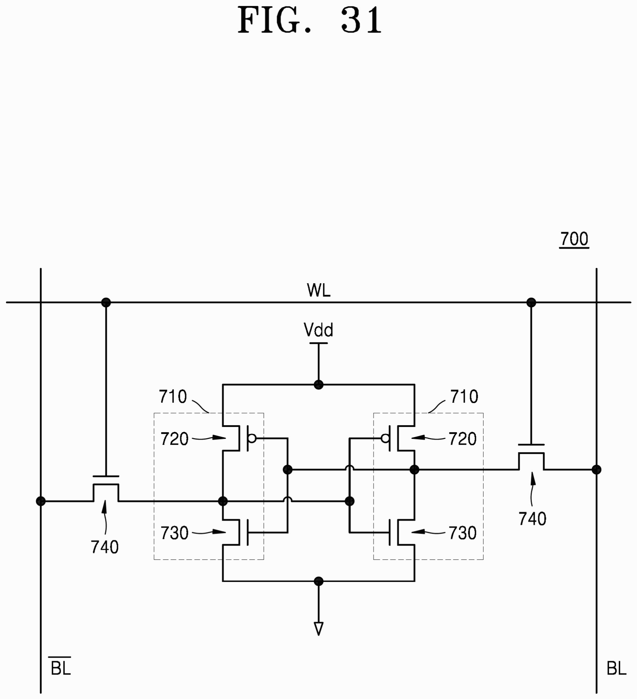

FIG. 31 is a circuit diagram of a CMOS SRAM device 700 according to an example embodiment.

The CMOS SRAM device 700 may include a pair of driving transistors 710. Each of the pair of driving transistors 710 may include a PMOS transistor 720 and an NMOS transistor 730 connected between a power terminal Vdd and a ground terminal. The CMOS SRAM device 700 may further include a pair of transmission transistors 740. A source of the transmission transistor 740 may be cross-connected to a common node of the PMOS transistor 720 and the NMOS transistor 730 constituting the driving transistor 710. The power terminal Vdd may be connected to a source of the PMOS transistor 720, and the ground terminal may be connected to a source of the NMOS transistor 730. A word line WL may be connected to gates of the pair of transmission transistors 740, and a bit line BL and an inverted bit line may be connected to drains of the pair of transmission transistors 740, respectively.

At least one of the driving transistor 710 or the transmission transistor 740 of the CMOS SRAM device 700 may include the semiconductor devices according to the example embodiments described above with reference to FIGS. 1 to 28B.

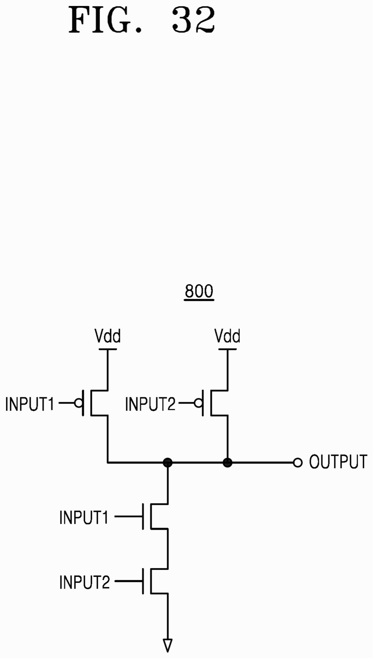

FIG. 32 is a circuit diagram of a CMOS NAND circuit 800 according to an example embodiment.

The CMOS NAND circuit 800 may include a pair of CMOS transistors to which different input signals are transmitted. The CMOS NAND circuit 800 may include the semiconductor devices according to the example embodiments described above with reference to FIGS. 1 to 28B.

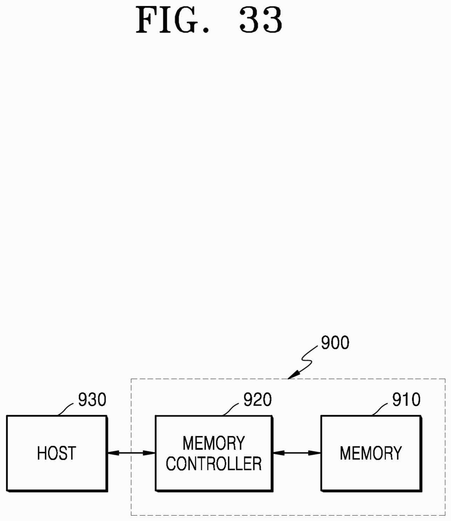

FIG. 33 is a block diagram illustrating an electronic system 900 according to an example embodiment.

The electronic system 900 may include a memory 910 and a memory controller 920. The memory controller 920 may control the memory 910 to read data from the memory 910 and/or write data into the memory 910 in response to a request from a host 930. At least one of the memory 910 or the memory controller 920 may include the semiconductor devices according to the example embodiments described above with reference to FIGS. 1 to 28B.

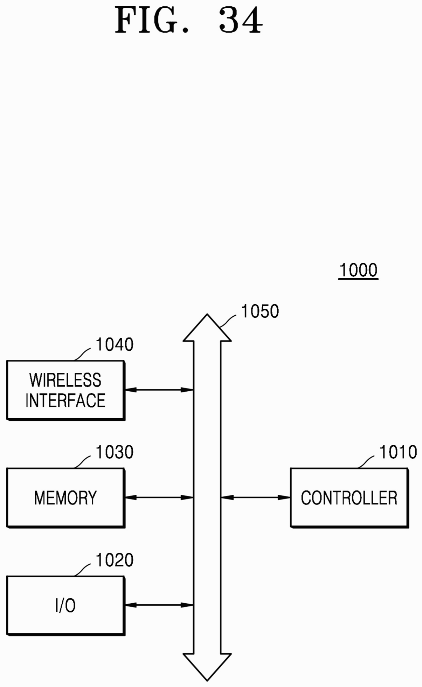

FIG. 34 is a block diagram of an electronic system 1000 according to an example embodiment.

The electronic system 1000 may configure a wireless communication apparatus or an apparatus capable of transmitting and/or receiving information in a wireless environment. The electronic system 1000 may include a controller 1010, an input/output (I/O) device 1020, a memory 1030, and a wireless interface 1040, which may be connected to each other through a bus 1050.

The controller 1010 may include at least one of a microprocessor, a digital signal processor, or any similar processors. The I/O device 1020 may include at least one of a keypad, a keyboard, or a display. The memory 1030 may be used to store a command executed by the controller 1010. For example, the memory 1030 may be used to store user data. The electronic system 1000 may use the wireless interface 1040 to transmit/receive data through a wireless communication network. The wireless interface 1040 may include an antenna and/or a wireless transceiver. In some example embodiments, the electronic system 1000 may be used in the communication interface protocols of third-generation communication systems such as Code Division Multiple Access (CDMA), Global System for Mobile Communications (GSM), North American Digital Cellular (NADC), Extended Time Division Multiple Access (E-TDMA), and/or Wideband Code Division Multiple Access (WCDMA). The electronic system 1000 may include the semiconductor devices according to the example embodiments described above with reference to FIGS. 1 to 28B.

The semiconductor devices according to some example embodiments may exhibit good electrical performance with an ultra-small structure and thus may be applied to IC devices and may implement miniaturization, relatively low power consumption, and/or relatively high performance.

Although the semiconductor devices and the semiconductor device manufacturing methods have been described above with reference to some example embodiments illustrated in the drawings, these are just a examples and those of ordinary skill in the art will understand that various modifications and other equivalent example embodiments may be derived therefrom. Although many details have been described above, they are not intended to limit the scope of the disclosure but should be interpreted as some examples. Therefore, the scope of the disclosure should be defined not by the described example embodiments but by the technical scope described in the following claims.

The semiconductor device according to an example embodiment may effectively reduce contact resistance. The semiconductor device according to an example embodiment may increase electron mobility by including a channel including a two-dimensional material and may increase gate controllability because it has a structure in which a gate electrode surrounds a wide surface of the channel. The semiconductor device manufacturing method according to an example embodiment may provide a method of manufacturing a semiconductor device having a structure that provides electrical doping.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A semiconductor device comprising:
a substrate;
a source electrode on the substrate;
a drain electrode on the substrate, the drain electrode being apart from the source electrode;
a channel being between the source electrode and the drain electrode, the channel connecting the source electrode to the drain electrode, the channel comprising a two-dimensional material;
a gate insulating layer on the channel; and
a gate electrode on the gate insulating layer, wherein
the gate electrode has an asymmetrical structure in terms of an overlap area facing a corresponding one of the source electrode and the drain electrode in a vertical direction, and
the gate electrode comprises the overlap area facing the source electrode in the vertical direction.

2. The semiconductor device of claim 1, wherein
the gate insulating layer has an asymmetrical structure in terms of an upper surface portion thereof facing a corresponding one of the source electrode and the drain electrode in the vertical direction, and
the gate insulating layer comprises the upper surface portion facing the source electrode in the vertical direction,
and/or
wherein the gate electrode has no area facing the drain electrode in the vertical direction.

3. The semiconductor device of claim 1 or 2, wherein the channel comprises at least one of a transition metal dichalcogenide (TMD) material, graphene, black phosphorus, amorphous boron nitride, or phosphorene,
in particular,
wherein the TMD material comprises a metal element selected from Mo, W, Nb, V, Ta, Ti, Zr, Hf, Tc, Re, Cu, Ga, In, Sn, Ge, and Pb and a chalcogen element selected from S, Se, and Te.

4. The semiconductor device of one of the previous claims, wherein the gate insulating layer comprises at least one of a high-k material or a ferroelectric material.

5. The semiconductor device of one of the previous claims, wherein the channel comprises a plurality of channel layers, the plurality of channel layers being apart from each other in a direction away from the substrate,
in particular,
wherein the plurality of channel layers have a structure in which both end portions thereof are buried in the source electrode and the drain electrode.

6. The semiconductor device of claim 5, further comprising:
a spacer between a corresponding pair of the plurality of channel layers, the spacer supporting the corresponding pair of the plurality of channel layers,
in particular,
wherein the spacer comprises at least one of SiO₂, SiN, or a-BN.

7. The semiconductor device of claim 6, wherein the spacer comprises a first spacer adjacent to the source electrode and a second spacer adjacent to the drain electrode,
in particular,
wherein the first spacer has a smaller thickness than the second spacer.

8. A semiconductor device comprising:
a substrate;
a source electrode on the substrate;
a drain electrode on the substrate, the drain electrode being apart from the source electrode;
a channel being between the source electrode and the drain electrode, the channel connecting the source electrode to the drain electrode to the channel, the channel comprising a two-dimensional material, the channel comprising a plurality of channel layers, the plurality of channel layers being apart from each other in a direction away from the substrate;
a spacer between a corresponding pair of the plurality of channel layers, the spacer supporting the corresponding pair of the plurality of channel layers;
a gate insulating layer on the plurality of channel layers; and
a gate electrode on the gate insulating layer, wherein
the spacer comprises a first spacer adjacent to the source electrode and a second spacer adjacent to the drain electrode, and
the first spacer has a smaller thickness than the second spacer.

9. The semiconductor device of claim 8, wherein the channel comprises at least one of a transition metal dichalcogenide (TMD) material, graphene, black phosphorus, amorphous boron nitride, or phosphorene.

10. The semiconductor device of claim 9, wherein the TMD material comprises a metal element selected from Mo, W, Nb, V, Ta, Ti, Zr, Hf, Tc, Re, Cu, Ga, In, Sn, Ge, and Pb and a chalcogen element selected from S, Se, and Te.

11. The semiconductor device of claim 9 or 10, wherein the gate insulating layer comprises at least one of a high-k material or a ferroelectric material.

12. The semiconductor device of one of claims 9 to 11, wherein the plurality of channel layers have a structure in which both end portions thereof are buried in the source electrode and the drain electrode.

13. The semiconductor device of one of claims 9 to 12, wherein the spacer comprises at least one of SiO₂, SiN, or a-BN.

14. A semiconductor device manufacturing method comprising:
alternately stacking a sacrificial layer and a channel on a substrate, the channel comprising a two-dimensional material;
patterning a stack structure of the sacrificial layer and the channel by using a mask;
forming a source electrode and a drain electrode on both sides of the patterned stack structure, respectively;
removing the sacrificial layer such that the channel is suspended between the source electrode and the drain electrode, the channel including a plurality of channel layers, the plurality of channel layers being apart from each other in a direction perpendicular to the substrate;
forming a first spacer adjacent to the source electrode and a second spacer adjacent to the drain electrode, between an adjacent pair of the plurality of channel layers;
depositing a gate insulating layer on the channel; and
depositing a gate electrode on the gate insulating layer,
wherein the first spacer has a smaller thickness than the second spacer.

15. The semiconductor device manufacturing method of claim 14, wherein the first spacer and the second spacer comprise at least one of SiO₂, SiN, or a-BN.
